(19) Europäisches Patentamt / European Patent Office / Office européen des brevets

(11) **EP 2 761 751 B1**

(12) **EUROPEAN PATENT SPECIFICATION**

(45) Date of publication and mention
of the grant of the patent:
**09.06.2021 Bulletin 2021/23**

(51) Int Cl.:
**H03K 5/19** *(2006.01)*

(21) Application number: **12768768.9**

(86) International application number:
**PCT/EP2012/068864**

(22) Date of filing: **25.09.2012**

(87) International publication number:
**WO 2013/045441 (04.04.2013 Gazette 2013/14)**

(54) **MONITORING OF PULSE WIDTH MODULATION CONTROL**

ÜBERWACHUNG DER PULSWEITENMODULATIONSSTEUERUNG

SURVEILLANCE DE CONTRÔLE DE MODULATION DE LARGEUR D'IMPULSION

(84) Designated Contracting States:
**AL AT BE BG CH CY CZ DE DK EE ES FI FR GR HR HU IE IS IT LI LT LU LV MC MK MT NL NO PL PT RO RS SE SI SK SM TR**

(30) Priority: **28.09.2011 GB 201116714**

(43) Date of publication of application:
**06.08.2014 Bulletin 2014/32**

(73) Proprietor: **Tridonic Uk Ltd**
**Chineham, Basingstoke RG24 8LB (GB)**

(72) Inventor: **WOOD, Anthony John**
**Spennymoor DL16 6JE (GB)**

(74) Representative: **Rupp, Christian**
**Mitscherlich PartmbB**
**Patent- und Rechtsanwälte**
**Sonnenstraße 33**
**80331 München (DE)**

(56) References cited:
**GB-A- 2 460 066      JP-A- 2011 176 398**
**US-A- 3 458 822      US-A- 4 230 958**
**US-A- 5 781 039      US-A- 5 907 250**
**US-A1- 2007 120 543**

EP 2 761 751 B1

# Description

## TECHNICAL FIELD

The present invention relates to a pulse width modulation control monitoring apparatus, a pulse width modulation control system including a pulse width modulated control signal generator for controlling one or more devices and including such a pulse width modulation control monitoring apparatus, and to a method of monitoring pulse width modulation control.

## BACKGROUND TO THE INVENTION

Pulse Width Modulation (PWM) signals are known to be used for providing control in many applications, such as the control of switched mode power supplies. The PWM signals may be generated by any suitable means, such as a microcontroller or other control circuit.

For example, PWM signals are used in electronic ballasts, such as for operating gas discharge lamps. The input of a typical electronic ballast is formed by means of a high frequency filter connected to the mains supply, which high frequency filter is connected with a rectifier circuit. The rectified supply voltage from the rectifier circuit is fed to a smoothing circuit for the generation of an intermediate circuit voltage, and finally an inverter fed with the intermediate circuit voltage generates a high frequency a.c. voltage, which is applied to the load circuit with, e.g., a gas discharge lamp connected thereto. The inverter may comprise a so-called half-bridge.

For operation of the half bridge of the inverter, a control circuit detects, for monitoring the load circuit current, preferably the voltage dropping over a resistance arranged at the foot of the half-bridge, and compares this with reference voltages. The monitoring of the current is then effected during the switch-on phase of the lower switch of the half-bridge. Beyond this, after the switching off of one of the two switches and before the following switching on of the other switch there is provided a predetermined delay time ("dead time"), in order to exclude a short-circuiting of the inverter. The switches are preferably MOS field effect transistors, the gates of which are controlled by the control circuit by means of PWM signals.

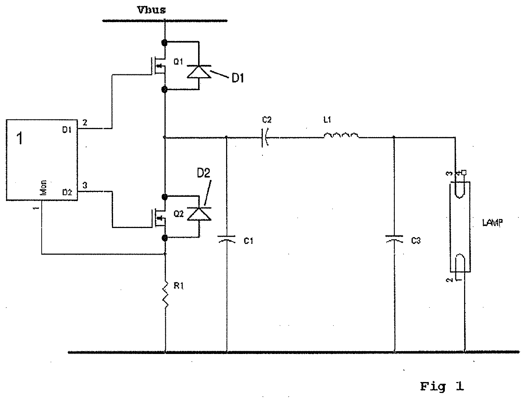

Components of such a ballast are illustrated in the circuit diagram in Figure 1. Further elements of the ballast arranged upstream of the inverter - for example the rectifier and smoothing circuit - are already well known and are not explained in more detail below.

The inverter is formed by means of a half-bridge of two electronic switches Q1 and Q2 connected in series. These switches Q1 and Q2 may be formed for example by means of two MOS field effect transistors. The switches have respective body diodes D1 and D2 associated therewith. The foot of the half-bridge is connected with ground via a shunt resistance R1, whilst at the input of the half-bridge the d.c. voltage Vbus is applied, which can for example be generated by shaping the mains voltage by means of a combination of radio frequency suppressor and rectifier. Alternatively to this there can, however, also be applied to the half-bridge any other d.c. voltage source.

At the common node point of the two switches Q1 and Q2, there is preferably connected the load circuit containing the gas discharge lamp LAMP, which is preferably a fluorescent lamp. This comprises of a series resonance circuit, which is made up of a choke L1 and a resonance capacitance C3.

The control of the two switches Q1, Q2 of the inverter is effected by means of a control circuit 1, which passes control signals to the gates of the two field effect transistors Q1 and Q2. The high side switch Q1 is driven by HS (high side) drive HSOUT 2 of the control circuit 1. The low side switch Q2 is driven by LS (low side) drive LSOUT 3 of the control circuit 1.

A switching period begins with a switching on or closing of the upper switch Q1 of the half-bridge for a certain switching-on time ton. At the end of this switch-on time ton the switch Q1 is again opened, and alternatingly the switch Q2 closed. Between the opening of the switch Q1 and the following closing of the switch Q2 a dead time TD is waited out, in order in any event to avoid a simultaneous closing of the two switches Q1, Q2 and therewith a short-circuiting of the inverter. Also the second switch Q2 is closed for the switch-on time ton and thereafter again opened. After a further waiting out of the dead time TD the upper switch Q1 is again closed, with which a complete switching period is ended. PWM signal from the control circuit 1 are used to control the switches Q1 and Q2.

PWM signals are used in emergency lighting applications. Emergency lighting devices are indispensable in order to realise, in relatively large buildings or complexes, lighting systems that make sufficient illumination available in the case of failure of the general mains supply. Only when, in the case of failure of the power supply or in other emergencies, certain relevant premises or areas are still illuminated can evacuation measures or remedial measures be carried out safely. Accordingly, emergency lighting devices of such a type are employed, in particular, for the purpose of illuminating escape routes and such like.

Emergency lighting devices of the generic type accordingly exhibit by way of a central element an energy storage unit - in particular, a battery or an accumulator - which during normal operation or charging operation is charged by the general mains supply voltage. For this purpose a charging circuit is provided which is connected to the mains supply voltage on the input side and during charging operation continually supplied energy to the energy storage unit, which stores this energy. Only in the case where an emergency condition arises - which is ordinarily detected autonomously by devices of such a type through a monitoring of the mains supply voltage - is a change-over made to emergency lighting operation, in which an emergency light source is activated and operated, to which end - where required - the energy made available by the energy storage unit is utilised. Since the storage capacity of the energy storage unit is of course limited, light sources are preferably employed that consume relatively little energy. Accordingly, emergency lighting devices of such a type are preferably equipped with gas-discharge lamps, in particular fluorescent tubes. However, light sources in the form of light-emitting semiconductors, in particular LEDs, are also increasingly finding application, since these light sources also exhibit a high efficiency and can accordingly be employed in an energy-saving manner.

In some lighting systems, the same light source is used both in emergency and normal lighting.

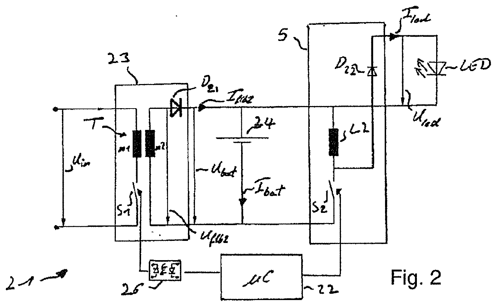

An emergency lighting device is represented in simplified manner in Fig. 2, designated generally with the reference symbol 21, and is provided for the purpose of operating an LED by way of emergency light source. The emergency lighting device 21 is connected on the input side to a power-supply network, which makes a mains supply voltage $U_{in}$ available, and includes a control unit 22, a charging circuit 23, an energy storage unit 24 in the form of a battery or an accumulator, and also a driver circuit 25.

The charging circuit 23 is constituted, in this example, by a so-called flyback converter which exhibits, on the one hand, a transformer T with a primary winding n1 and a secondary winding n2 and also, on the other hand, a controllable switch S1. In known manner, by an appropriate alternating opening and closing of the switch S1 the energy made available by the mains supply voltage $U_{in}$ is transmitted to the secondary side of the flyback converter 23 and utilised for the purpose of charging the energy storage unit 24. The transmission of energy takes place in the open state of the switch S1, wherein for this purpose a diode $D_{21}$ is furthermore provided on the output side of the flyback converter 23. Flyback circuits of such a type often find application in emergency lighting devices of such a type by reason of their simple structure and their reliable functioning.

Triggering of the controllable switch S1 is undertaken by the control unit 22 of the emergency lighting device, the triggering being undertaken, in particular, in galvanically isolated manner via an optocoupler 26. In this connection the control unit 22 controls the switch S1 in alternating manner, the so-called duty cycle D1 for the switching operation of the switch S1 being calculated as follows:

$$D1 = t_{on1}/(T - t_{on1})$$

where $t_{on\,1}$ corresponds to the on-time of the switch, whereas T denotes the total period of a complete switching cycle for the switch S1.

During charging operation of the emergency lighting device 21, ordinarily only the charging circuit 23 is active, in order to charge the battery 24 continually. Only in the case where an emergency condition obtains - which is characterised, in particular, by deviations in the mains supply voltage $U_{in}$ from predetermined set values - is emergency lighting operation initiated, in which the driver circuit 25 is utilised for the purpose of triggering the LED. The driver circuit 25, which takes for form of a switching regulator, exhibits for this purpose a further controllable switch S2, an inductance coil L2 and also a diode $D_{22}$. By alternating triggering of the switch S2 by the control unit 22, in this way a current is made available to the LED, via which the latter is operated. The pulse duty factor with which the switch S2 is triggered by the control unit 22 may in this connection be varied, in order to adjust the level of the current supplied to the LED, and hence the power at which the LED is operated. In this way it is possible to ensure in very elegant manner that also in the case of fluctuating battery power the LED is operated, despite everything, with constant brightness.

PWM signals from the control unit 22 are used to control switches S1 and S2.

When using a microcontroller or other control device to provide Pulse Width Modulation signals to switched mode power supplies and other devices, it is possible that under some conditions that some microcontrollers (or control devices) can stop their clock without warning, which results in the PWM signals not being varied in the programmed manner. Normally a watchdog circuit would time out when the clock stops and resets the processor. Such a watchdog circuit monitors software routines and checks that they are operating correctly. Such a watchdog circuit may take 10ms or more to react to the pulse stopping. The pulses themselves are not monitored directly. Such a reaction time for PWM signals this is too slow and can result in damage to equipment. US 5,907,250 A discloses a circuit for detecting the absence of signal transitions after a set period of time from the last transition.

SUMMARY OF THE INVENTION

In a first aspect the present invention provides a pulse width modulation control monitoring apparatus as defined in claim 1 including input means operable to receive at least one pulse width modulated control input signal and to provide an output signal therefrom, and threshold means operable to detect when the frequency of the output signal falls below a threshold.

The pulse width modulation control may be that applied to control a lighting system in general or an emergency lighting system and may control a switched mode power supply - for example, to control the half-bridge of an inverter or to control the charging and/or discharging of a battery or other energy storing device in a lighting system, such as an emergency lighting system.

The input means includes edge detection means operable to detect edges of the at least one pulse width modulated control signal and to generate the output signals so that it is indicative of the detected edges. Such an edge detection means may comprise a differentiator, such as passive differentiator circuit.

The threshold means is operable to monitor the time between peaks in the output signal corresponding to the detected edges and to derive the frequency therefrom. In the embodiment the peaks in the output signal correspond to the points where the output signal has the maximum rate of change. Where the output signal is increasing, a positive peak will be generated, and where the output signal is decreasing, a negative peak will be generated. The threshold means monitors the time between adjacent positive peaks or adjacent negative peaks.

The input means is operable to receive a plurality of pulse width modulated control signals and to combine them into a single signal.

The plurality of pulse width modulated control signals are a first control signal applied to a first switch of a half-bridge and a second control signal applied to a second switch of the half-bridge. Alternatively, the first control signal may be the control signal applied to the switch of a flyback converter of a charging circuit for an energy storing device of an emergency lighting system, and the second control signal may be the control signal applied to the switch of an LED driver circuit to adjust the level of current applied to the LED. In the first of these applications the first and second control signals are applied concurrently (that is, the first and second switches are opened alternately) to each other, whereas in the second application either the first switch is operated in an alternating manner or the second switch is operated in an alternating manner, but both switches are not operated in the alternating manner at the same time.

The pulse width modulation control monitoring apparatus is also suitable for monitoring in many other types of applications in which pulse width modulated control input signals are generated, and where it is desirable to monitor the correct generation of these signals. Where a plurality of pulse width modulated control input signals are monitored, these may be signals that alternate concurrently or successively.

When the input means receives a plurality of pulse width modulated control signals and combines them into a single signal, the input means may combine the signals by performing a logical OR operation. By combining the pulse width modulated control signals into a single signal, only a single edge detection means and a single threshold means is required in order to monitor that single signal, thereby improving cost efficiency. The ability to monitor a plurality of pulse width modulated control input signals is maintained despite the reduced number of components (single edge detection means and single threshold means).

The present invention also provides a pulse width modulation control system including a pulse width modulated control signal generator for controlling one or more devices, and the pulse with modulation control monitoring apparatus as discussed above.

In a further aspect the present invention provides a lighting system controlled by pulse width modulation control signals, comprising the pulse width modulation control monitoring apparatus defined above or the pulse width modulation control system defined above.

In another aspect the present invention provides a battery discharge and/or charge system controlled by pulse width modulation control signals, comprising the pulse width modulation control monitoring apparatus as defined above or the pulse width modulation control system as defined above.

The present invention also provides a method of monitoring pulse width modulation control as defined in claim 7.

The embodiment provides a novel circuit such that detection and PWM shutdown can be performed very quickly, and timed such that there is no accumulation of currents that would otherwise cause damage. In the example of a half bridge and the like, it is normal to arrange protection such that both pulses are never "high" at the same time (i.e. a dead time is provided, sometimes called shoot-through protection), but the embodiment is different in that it will monitor the pulse widths of either (or both) pulses. This technique may operate over a great range of the PWM duty (mark-space ratio) and can operate with single or multiple PWM sources. PWM signals from multiple sources are OR'd together. The system works irrespective of the number of PWM sources. The OR'd PWM signals are then differentiated. The time between adjacent peeks is then measured. If the time exceeds a threshold a signal is sent to deactivate the PWM generators to an inactive, safe state.

BRIEF DESCRIPTION OF THE DRAWINGS

For a better understanding of the present invention an embodiment will now be described by way of example, with reference to the accompanying drawings, in which:

Figure 1 shows the inverter circuit of an electronic ballast for operating a gas discharge lamp and which comprises a half-bridge of known configuration;

Figure 2 shows a circuit diagram of an emergency lighting device which includes a charging circuit and an LED driver circuit of known configuration;

Figure 3 shows a functional block diagram of important elements of an embodiment of the pulse width modulation control monitoring apparatus of the present invention;

Figure 4 shows a circuit diagram for implementing the pulse width modulation control monitoring apparatus of Figure 3;

Figures 5A and 5B show example input pulse width modulated waveforms monitored by the pulse width modulation control monitoring apparatus of the embodiment, and Figures 5C and 5D show the processing of the signals in accordance with the embodiment; and

Figures 6A and 6B show alternative example input pulse width modulated waveforms monitored by the pulse width modulation control monitoring apparatus of the embodiment, and Figures 6C and 6D show the processing of the signals in accordance with the embodiment.

## DETAILED DESCRIPTION OF EMBODIMENT OF THE INVENTION

Briefly, in the embodiment a pulse width modulation control monitoring apparatus is provided with input means that receives at least one pulse width modulated control input signal. If a plurality of input signals are provided, these are combined into a single signal by a logical OR operation. Edge detection means then detects edges of the or the combined pulse width modulated control signal and generates and output signal that is indicative of the detected edges. A timer determines whether the period between the detected edges exceeds a predetermined threshold, which is indicative of an error in the or one of the pulse width modulated control input signals. An alarm signal is then generated to shut down the pulse width modulated control to avoid potential damage caused, for example, by excessive current in a power supply.

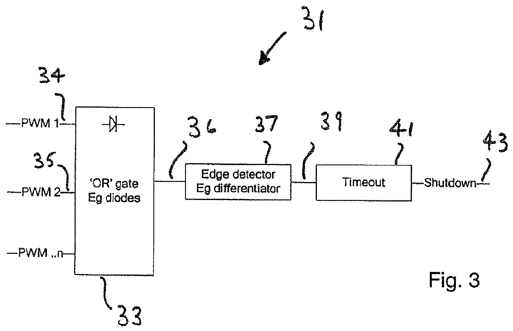

Figure 3 shows a functional block diagram of an embodiment of the present invention, comprising a pulse width modulation control monitoring apparatus designated generally at 31.

The apparatus includes input means 33 that receives a plurality of pulse width modulated control input signals, PWM 1, PWM 2, ..., PWM..n. For example, the input means 33 may receive two pulse width modulation control input signals at its inputs 34 and 35, such as the signals used to control the switches Q1 and Q2, respectively, of the half-bridge inverter of Figure 1, or the signals used to control the switches S1 and S2, respectively, of emergency lighting device of Figure 2. However, it should be appreciated that the input means 33 may receive more than two pulse width modulated control input signals. It should also be appreciated that the input means 33 may receive two pulse width modulated control input signals from devices other than a half-bridge inverter or an emergency lighting device.

The input means 33 may include a respective diode for receiving each of the pulse width modulated control input signals. After passing through the respective diode, the signals are combined to form a single signal.

Thus, the input means 33 performs a Boolean logical OR operation of the pulse width modulated control input signals.

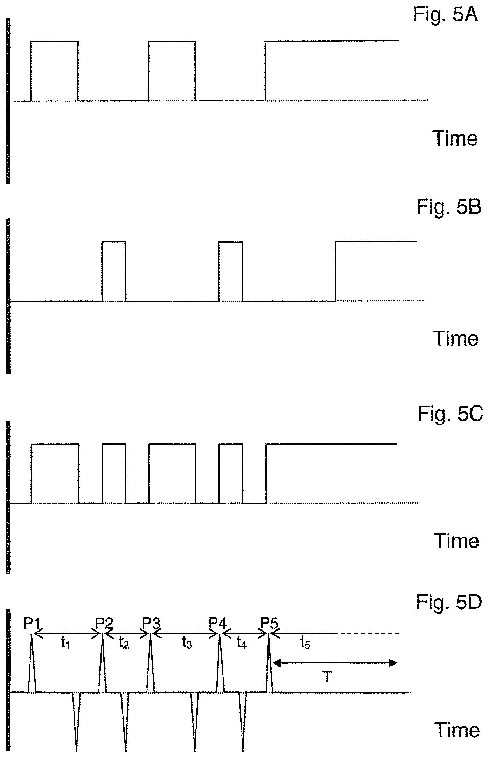

Figure 5A shows an example of pulse width modulated control signal waveform PWM 1 applied to a first input 34 of the input means 33. Figure 5B shows a second pulse width modulated control signal PWM 2 applied to the second input 35 of the input means 33. The control signal waveforms are square waves which alternate between a high and a low value. The "high" time of each pulse of the signal of Figure 5A has twice the duration of the "high" time of the signal of Figure 5B, and the "high" times occur alternately. Such input signals are used for the sake of clarity of the explanation of the operation of the input means 33, and of course the input means 33 may combine signals of other "high" times and with different (and varying) frequencies.

The signal of Figure 5A is passed from the first input 34 to a first diode, and the input signal of Figure 5B is passed from the second input 35 to a second diode. The signals from the diodes are then combined to form a single signal. The operation of the input means 33 is to perform a logical OR operation on the two input signals, and produces a combined output signal that is derived from both the input signals. The output signal produced by the input means 33 is shown in Figure 5C. As can be seen, the output signal of Figure 5C includes a pulse corresponding to each of the pulses of the respective first and second input signals of Figures 5A and 5B.

The single output signal 36 of the input means 33 is then applied to an edge detector 37. The edge detector 37 may be a differentiator circuit which converts the pulse edges of the output signal 36 of the input means 33 into delta pulses (short duration pulses) in a known manner to produce an edge detector output signal 39. Figure 5D shows the edge detector output signal 39. The amplitude of the output signal 39 is proportional to the rate of change of the combined output signal 36 shown in Figure 5C.

A timer function 41 receives the edge detector output signal 39 and measures the time between adjacent positive pulses. If the time between the pulses exceeds a threshold T, then the timer function 41 issues an alarm signal at its output 43.

Referring to Figure 5D, the timer function 41 is configured to detect the first positive pulse P1 and to reset a timer in response thereto. The timer then counts the time $t_1$ until the subsequent positive pulse P2 is detected, or until the timer reaches a threshold value T and expires. If the time period $t_1$ is below the threshold value T, on detection of the second pulse P2, the timer is reset and again either counts the period $t_2$ until the third pulse P3 is detected or until the timer reaches the threshold value T. The subsequent pulses P4 and P5 are detected and the time period $t_3$ and $t_4$ are counted out by the timer in a similar manner. In this example each of the time periods $t_1$, $t_2$, $t_3$ and $t_4$ is below the threshold value T of the timer. However, after the timer is reset by detection of the fifth positive pulse P5, the absence of any pulse in the signal 39 for an extended period of time results in the time period $t_5$ from detection of the fifth pulse P5 exceeding the timer threshold T. When this occurs the timer 41 issues an alarm signal at output 43.

In this example, as discussed, the time between adjacent positive pulses is detected. The timer 41 may alternatively be configured to detect the time between adjacent negative pulses.

A very simple circuit can be used to implement the described technique, for example using discrete components, although this could also be embodied using logic circuits and the like.

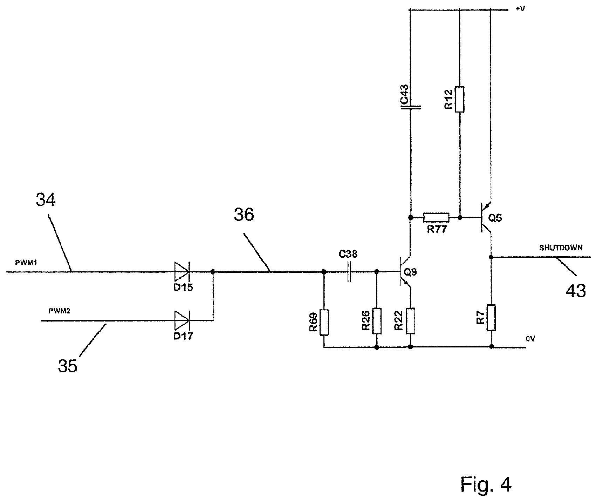

Figure 4 shows such a circuit. Here, two diodes D15,D17 and resistor R69 are used to implement the input means 33 and perform the logical OR function, to combine the PWM 1 and PWM 2 signals at inputs 34 and 35 into a single input signal 36. The output signal 36 is high when either of the inputs 34 or 35 is high.

A capacitor/resistor circuit capacitor C38 and resistor R26 implement the edge detector 37 and provides any positive or negative going edge detection, i.e. to function as a differentiator.

The timer function of the timer 41 is performed by switch Q9, resistor R22, capacitor C43, resistor R77, resistor R12, switch Q5 and resistor R7.

Switch Q9 and resistor R22 produce current pulses at the Q9 collector to reset the timer by charging capacitor C43.

Therefore the voltage at the collector of switch Q5 is normally high when detecting normal PWM pulses but will go low upon a stuck pulse being detected, i.e. after the timer interval T has expired. The low value may be used as an alarm signal 43 that can be fed into a microcontroller shutdown pin, or other circuits, to immediately shut off the PWM pulses.

In a pulse width modulation control system, when a pulse is generated it can be one of two states: high or low. In a power circuit, one of the states will cause conduction of the power circuit, and it is in this state that protection is required because if conduction occurs for too long this will usually lead to a very large build up of current, possibly damaging the power circuit.

In this embodiment the high (or positive) pulse state causes conduction, but of course the invention is also applicable to arrangements in which the low (or negative) state causes conduction, in which case the input means 33 may be modified to invert the input signals 34 and 35 before performing the logical OR operation. In other words, the entire scheme could be implemented as "stuck-low" protection if desired, by changing the logical OR function to a logical NAND function. This would then only protect low states using the negative going edges.

If the pulse width modulation control system is for a half-bridge inverter of the type shown in Figure 1, then a first pulse width modulated signal is generated for controlling the first switch Q1, and a second pulse width modulated control signal is generated for controlling the second switch Q2. Depending on the circumstances, these pulse width modulated control signals may have the general form of the signals shown in Figures 5A and 5B. That is, the respective pulse width modulated signals are alternately high and there exists a "dead time" between each of the signals being high, during which both of the signals are low. The pulse width modulated control signals are applied to the gates of the respective switches Q1 and Q2 that are implemented as field effect transistors. When a high signal is applied to the gate of the field effect transistor, this turns on (closes) the switch. The dead time is provided to prevent the simultaneous closing of the two switches Q1 and Q2.

The pulse width modulation control system receives as the input signals PWM 1 and PWM 2 the signals applied to the gate of the switches Q1 and Q2, at inputs 34 and 35.

If one or other (or both - as shown in Figures 5A and 5B) of the pulse width modulated control signals gets stuck in the high state (for example, due to malfunctioning of the pulse width modulation control system), then there will be no subsequent positive (and negative) pulses detected by the edge detector 37 and the timer 41 will expire after the threshold is exceeded and the alarm signal 43 will be generated to shut down the pulse width modulating control system to avoid damaging the half-bridge by the high current.

If both of the pulse width modulated control signals get stuck in the low state (for example, due to malfunctioning of the pulse width modulation control system), then there will be no subsequent positive (and negative) pulses detected by the edge detector 37 and the timer 41 will expire after the threshold is exceeded and the alarm signal 43 will be generated to shut down the pulse width modulating control.

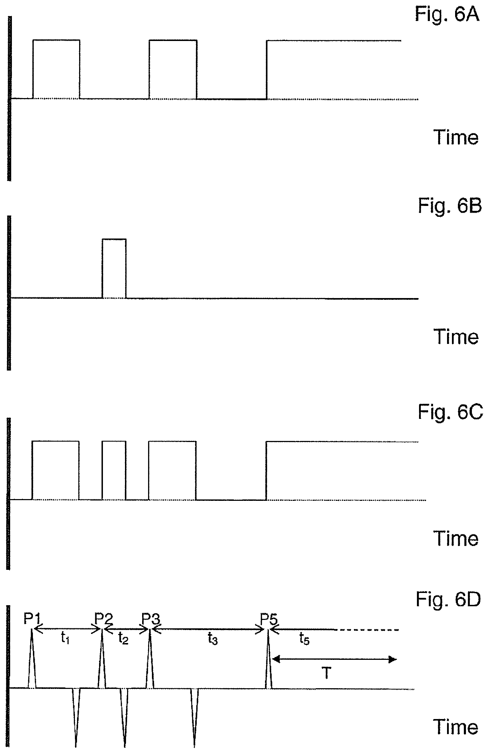

Alternatively, if one of the pulse width modulation control signals generated by the pulse width modulation control systems gets stuck in the low state, the output 36 of the input means 33 will then, by virtue of the logical OR function, simply correspond to the other pulse width modulation control signal. The edge detector 37 will then detect the edges of just this functioning pulse width modulation control signal, and the timer 41 will measure the time between adjacent positive pulses. If the time between the adjacent positive pulses exceeds the threshold T, then the alarm signal 43 will be generated in order to shut down the half-bridge to prevent damage. This is shown in the waveforms of Figures 6A-D, in which the waveform of Figure 6B becomes stuck in the low state. For the pulse width modulated signal that is stuck in the low state, this will result in the relevant switch remaining in the off state and no damage will occur due to the switch being stuck in the off position and so no protection for such a state is required. However, if the other pulse width modulated control signal subsequently gets stuck high, this will be detected and the alarm signal 43 generated.

Thus, the pulse width modulation control monitoring apparatus of the embodiment is able to provide protection against failure of either one or two (or more) pulse with modulated signals whilst requiring only a single edge detector 37 and timer function 41.

The pulse width modulation control system is also highly effective when used in the very different scenario of an emergency lighting device of the type, for example, shown in Figure 2. In this arrangement a control unit 22 controls switch S1, the alternating operation of which charges the energy storage unit 24 using energy from the mains supply voltage Uin. The control unit 22 also controls the second switch S2, the alternating operation of which adjusts the level of the current applied to the LED and hence the power at which the LED is operated (and the brightness thereof). Unlike the inverter application, in which the switches Q1 and Q2 were both operated concurrently, the switches S1 and S2 in the emergency lighting application are generally not operating concurrently. When mains power is available and operating correctly the switch S1 is operated in an alternating opening and closing manner to charge the energy storage unit 24, and the switch S2 remains open as the LED emergency light is not required to be illuminated (because other light sources, powered by the mains, are available). When the mains supply is no longer available or malfunctions, this is detected by the control unit 22 in a suitable manner (examples of which are known to those skilled in the art), whereafter the control unit 22 no longer alternately opens and closes the switch S1 but instead alternately operates the switch S2 with an appropriate pulse duty factor to provide the desired level of illumination of the LED.

Thus, if the emergency light device of Figure 2 is operating correctly, either the first switch S1 or the second switch S2 will be applied with a pulse width modulated control signal from the control unit 22. The pulse width modulation control monitoring apparatus can effectively check proper operation of the control unit 22, regarding the generation of appropriate pulse width modulated output signals, by applying the pulse width modulated signal applied to the switch S1 to the first input 34 of the input means 33, and the pulse width modulated control signal for the second switch S2 to the second input 35 of the input means 33. The signals will be applied to respective diodes in the manner described above, and then combined (OR'd) to produce a single output 36. In this application, the single output, by virtue of the logical OR operation, will represent either the pulse width modulated control signal applied to the switch S1 or the pulse width modulated control signal applied to the switch S2 (as neither of those switches have a pulse width modulated control signal provided to them concurrently. The edge detector 37 detects pulse edges in the manner described above, and the timer 41 determines when the period between those edges exceeds the threshold T, again in the manner described above. Thus, if the control unit 22 malfunctions and does not provide a pulse width modulated control signal (as opposed to a signal with a constant high or low value) to either of the switches S1 or S2, this can be detected by the single edge detector 37 and timer 41 of Figure 3. Thus, the same circuit is able to protect two (or more) pulse width modulated control signals.

## Claims

1. A pulse width modulation control monitoring apparatus for monitoring a plurality of pulse width modulated control signals each being used for controlling a switching of a corresponding different switch, wherein the pulse width modulation control monitoring apparatus includes:

   • an input means (33, 37) operable to receive the plurality of pulse width modulated control signals and to combine them into a single signal and to provide an output signal based on the single signal,
   • wherein the input means (33, 37) includes an edge detection means operable to detect edges of the single signal and to generate the output signal so that it is indicative of the detected edges, and
   • a threshold means (41) operable to detect when a frequency of the output signal falls below a threshold,
   • wherein the threshold means (41) is operable to monitor the time between peaks in the output signal corresponding to the detected edges and to derive the frequency therefrom,
   • wherein the threshold means (41) comprises a first switch (Q9), a second switch (Q5), a number of resistors (R22, R77, R12, R7) and a capacitor (C43),
   • wherein the first switch (Q9) and one of the number of resistors (R22) is configured to produce a current pulse at the collector of the first switch (Q9) to reset the threshold means (41) by charging the capacitor (C43) in response to a peak in the output signal, and
   • wherein, if the time between the peaks in the output signal exceeds a threshold, a voltage at the collector of the second switch (Q5) is reduced.

2. The apparatus of claim 1, wherein the edge detection means comprises a differentiator.

3. The apparatus of any of the preceding claims, wherein the input means (33, 37) is operable to combine the plurality of pulse width modulation control signals by performing a logical OR operation.

4. A pulse width modulation control system including a pulse width modulated control signal generator for controlling one or more devices, and the pulse width modulation control monitoring apparatus of any one of the preceding claims.

5. A lighting system controlled by pulse width modulation control signals, comprising the apparatus of any one of claims 1 to 3 or the system of claim 4.

6. A battery discharge and/or charge system controlled by pulse width modulation control signals, comprising the apparatus of any one of claims 1 to 3 or the system of claim 4.

7. A method of monitoring a plurality of pulse width modulation control signals each being used for controlling a switching of a corresponding different switch, the method comprising the steps of:

• receiving a plurality of pulse width modulated control signals and combining them into a single signal and providing an output signal based on the single signal, and
• detecting when a frequency of the output signal falls below a threshold,
• detecting edges of the single signal and generating the output signal so that it is indicative of the detected edges,
• monitoring the time between peaks in the output signal corresponding to the detected edges and deriving the frequency therefrom,
• wherein the step of monitoring the time between peaks in the output signal is carried out by a threshold means (41), which comprises a first switch (Q9), a second switch (Q5), a number of resistors (R22, R77, R12, R7) and a capacitor (C43),
• wherein the first switch (Q9) and one of the number of resistors (R22) is configured to produce a current pulse at the collector of the first switch (Q9) to reset the threshold means (41) by charging the capacitor (C43) in response to a peak in the output signal, and wherein, if the time between the peaks in the output signal exceeds a threshold, a voltage at the collector of the second switch (Q5) is reduced.

8. The method of claim 7, wherein the edge detection is performed by a differentiator.

9. The method of claims 7 or 8, including combining the plurality of pulse width modulated control signals by performing a logical OR operation.

**Patentansprüche**

1. Pulsweitenmodulations-Steuerungsüberwachungsvorrichtung zum Überwachen einer Vielzahl von pulsweitenmodulierten Steuersignalen, die jeweils zum Steuern eines Schaltvorgangs eines entsprechenden unterschiedlichen Schalters verwendet werden, wobei die Pulsweitenmodulations-Steuerungsüberwachungsvorrichtung einschließt:

• ein Eingabemittel (33, 37), das betreibbar ist, um die Vielzahl von pulsweitenmodulierten Steuersignalen zu empfangen und sie zu einem Einzelsignal zu kombinieren und ein auf dem Einzelsignal basierendes Ausgangssignal bereitzustellen,
• wobei das Eingabemittel (33, 37) ein Flankenerfassungsmittel einschließt, das betreibbar ist, um Flanken des Einzelsignals zu erfassen und das Ausgangssignal so zu erzeugen, dass es die erfassten Flanken anzeigt, und
• ein Schwellenwertmittel (41), das betreibbar ist, um zu erfassen, wenn eine Frequenz des Ausgangssignals unter einen Schwellenwert fällt,
• wobei das Schwellenwertmittel (41) so betreibbar ist, dass es die Zeit zwischen Spitzen im Ausgangssignal, die den erfassten Flanken entsprechen, überwacht und daraus die Frequenz ableitet,
• wobei das Schwellenwertmittel (41) einen ersten Schalter (Q9), einen zweiten Schalter (Q5), eine Anzahl von Widerständen (R22, R77, R12, R7) und einen Kondensator (C43) umfasst,
• wobei der erste Schalter (Q9) und einer der Anzahl von Widerständen (R22) so konfiguriert ist, dass er einen Stromimpuls am Kollektor des ersten Schalters (Q9) erzeugt, um das Schwellenwertmittel (41) durch Laden des Kondensators (C43) als Reaktion auf eine Spitze im Ausgangssignal zurückzusetzen, und
• wobei, wenn die Zeit zwischen den Spitzen im Ausgangssignal einen Schwellenwert überschreitet, eine Spannung am Kollektor des zweiten Schalters (Q5) reduziert wird.

2. Vorrichtung nach Anspruch 1, wobei das Flankenerfassungsmittel einen Differenzierer umfasst.

3. Vorrichtung nach einem der vorstehenden Ansprüche, wobei das Eingangsmittel (33, 37) betreibbar ist, um die Vielzahl von Pulsweitenmodulations-Steuersignale durch Ausführen einer logischen ODER-Operation zu kombinieren.

4. Pulsweitenmodulations-Steuersystem mit einem pulsweitenmodulierten Steuersignalgenerator zur Steuerung einer oder mehrerer Vorrichtungen und der Pulsweitenmodulations-Steuerungsüberwachungsvorrichtung nach einem der vorstehenden Ansprüche.

5. Beleuchtungssystem, das durch Pulsweitenmodulations-Steuersignale gesteuert wird, umfassend die Vorrichtung nach einem der Ansprüche 1 bis 3 oder das System nach Anspruch 4.

6. Batterieentlade- und/oder -ladesystem, das durch Pulsweitenmodulations-Steuersignale gesteuert wird, umfassend die Vorrichtung nach einem der Ansprüche 1 bis 3 oder das System nach Anspruch 4.

7. Verfahren zum Überwachen einer Vielzahl von Pulsweitenmodulations-Steuersignalen, die jeweils zum Steuern eines Schaltvorgangs eines entsprechenden unterschiedlichen Schalters verwendet werden, das Verfahren umfassend die Schritte:

   • Empfangen einer Vielzahl von pulsweitenmodulierten Steuersignalen und Kombinieren dieser zu einem Einzelsignal und Bereitstellen eines Ausgangssignals basierend auf dem Einzelsignal, und
   • Erfassen, wenn eine Frequenz des Ausgangssignals unter einen Schwellenwert fällt,
   • Erfassen von Flanken des Einzelsignals und Erzeugen des Ausgangssignals, so dass es die erfassten Flanken anzeigt,
   • Überwachen der Zeit zwischen den Spitzen im Ausgangssignal, die den erfassten Flanken entsprechen, und Ableiten der Frequenz daraus,
   • wobei der Schritt des Überwachens der Zeit zwischen Spitzen im Ausgangssignal durch ein Schwellenwertmittel (41) ausgeführt wird, das einen ersten Schalter (Q9), einen zweiten Schalter (Q5), eine Anzahl von Widerständen (R22, R77, R12, R7) und einen Kondensator (C43) umfasst,
   • wobei der erste Schalter (Q9) und einer der Anzahl von Widerständen (R22) so konfiguriert ist, dass er einen Stromimpuls am Kollektor des ersten Schalters (Q9) erzeugt, um das Schwellenwertmittel (41) durch Laden des Kondensators (C43) als Reaktion auf eine Spitze im Ausgangssignal zurückzusetzen, und
   wobei, wenn die Zeit zwischen den Spitzen im Ausgangssignal einen Schwellenwert überschreitet, eine Spannung am Kollektor des zweiten Schalters (Q5) reduziert wird.

8. Verfahren nach Anspruch 7, wobei die Flankenerfassung durch einen Differenzierer durchgeführt wird.

9. Verfahren nach Anspruch 7 oder 8, einschließlich des Kombinierens der Vielzahl von pulsweitenmodulierten Steuersignalen durch Ausführen einer logischen ODER-Operation.

**Revendications**

1. Appareil de surveillance de commande de modulation de largeur d'impulsion pour la surveillance d'une pluralité de signaux de commande modulés en largeur d'impulsion étant utilisés chacun pour commander une commutation d'un commutateur différent correspondant, dans lequel l'appareil de surveillance de commande de modulation de largeur d'impulsion inclut :

   • un moyen d'entrée (33, 37) opérationnel pour recevoir la pluralité de signaux de commande modulés en largeur d'impulsion et pour les combiner en un signal unique et pour fournir un signal de sortie sur la base du signal unique,
   • dans lequel le moyen d'entrée (33, 37) inclut un moyen de détection de bord opérationnel pour détecter des bords du signal unique et pour générer le signal de sortie de sorte qu'il soit indicatif des bords détectés et
   • un moyen de seuil (41) opérationnel pour détecter lorsqu'une fréquence du signal de sortie descend en dessous d'un seuil,
   • dans lequel le moyen de seuil (41) est opérationnel pour surveiller le temps entre des crêtes dans le signal de sortie correspondant aux bords détectés et pour en dériver la fréquence,
   • dans lequel le moyen de seuil (41) comprend un premier commutateur (Q9), un deuxième commutateur (Q5), un nombre de résistances (R22, R77, R12, R7) et un condensateur (C43),
   • dans lequel le premier commutateur (Q9) et l'une parmi le nombre de résistances (R22) sont configurés pour produire une impulsion de courant au niveau du collecteur du premier commutateur (Q9) pour réinitialiser le moyen de seuil (41) en chargeant le condensateur (C43) en réponse à une crête dans le signal de sortie et
   • dans lequel, si le temps entre les crêtes dans le signal de sortie dépasse un seuil, une tension au niveau du collecteur du deuxième commutateur (Q5) est réduite.

2. Appareil selon la revendication 1, dans lequel le moyen de détection de bord comprend un différentiateur.

3. Appareil selon l'une quelconque des revendications précédentes, dans lequel le moyen d'entrée (33, 37) est opérationnel pour combiner la pluralité de signaux de commande de modulation de largeur d'impulsion en mettant en œuvre une opération logique OU.

**4.** Système de commande de modulation de largeur d'impulsion incluant un générateur de signal de commande modulé en largeur d'impulsion pour commander un ou plusieurs dispositifs et l'appareil de surveillance de commande de modulation de largeur d'impulsion de l'une quelconque des revendications précédentes.

**5.** Système d'éclairage commandé par des signaux de commande de modulation de largeur d'impulsion, comprenant l'appareil de l'une quelconque des revendications 1 à 3 ou le système de la revendication 4.

**6.** Système de décharge et/ou de charge de batterie commandé par des signaux de commande de modulation de largeur d'impulsion, comprenant l'appareil de l'une quelconque des revendications 1 à 3 ou le système de la revendication 4.

**7.** Procédé de surveillance d'une pluralité de signaux de commande de modulation de largeur d'impulsion étant utilisés chacun pour commander une commutation d'un commutateur différent correspondant, le procédé comprenant les étapes consistant à :

• recevoir une pluralité de signaux de commande modulés en largeur d'impulsion et les combiner en un signal unique et fournir un signal de sortie basé sur le signal unique et
• détecter lorsqu'une fréquence du signal de sortie descend en dessous d'un seuil,
• détecter des bords du signal unique et générer le signal de sortie de sorte qu'il soit indicatif des bords détectés,
• surveiller le temps entre des crêtes dans le signal de sortie correspondant aux bords détectés et en dériver la fréquence,
• dans lequel l'étape de surveillance du temps entre crêtes dans le signal de sortie est effectuée par un moyen de seuil (41), qui comprend un premier commutateur (Q9), un deuxième commutateur (Q5), un nombre de résistances (R22, R77, R12, R7) et un condensateur (C43),
• dans lequel le premier commutateur (Q9) et l'une parmi le nombre de résistances (R22) sont configurés pour produire une impulsion de courant au niveau du collecteur du premier commutateur (Q9) pour réinitialiser le moyen de seuil (41) en chargeant le condensateur (C43) en réponse à une crête dans le signal de sortie et dans lequel, si le temps entre les crêtes dans le signal de sortie dépasse un seuil, une tension au niveau du collecteur du deuxième commutateur (Q5) est réduite.

**8.** Procédé selon la revendication 7, dans lequel la détection de bord est mise en œuvre par un différentiateur.

**9.** Procédé selon la revendication 7 ou 8, incluant la combinaison de la pluralité de signaux de commande modulés en largeur d'impulsion en mettant en œuvre une opération logique OU.

Fig 1

Fig. 2

Fig. 3

Fig. 4

Fig. 5A

Time

Fig. 5B

Time

Fig. 5C

Time

Fig. 5D

P1   P2   P3   P4   P5

$t_1$   $t_2$   $t_3$   $t_4$   $t_5$

T

Time

Fig. 6A

Time

Fig. 6B

Time

Fig. 6C

Time

Fig. 6D

P1　　　P2　P3　　　　　P5

$t_1$　　$t_2$　　　$t_3$　　　$t_5$

T

Time

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5907250 A